(19) Europäisches Patentamt
European Patent Office
Office européen des brevets

(11) **EP 3 772 653 A1**

(12) **EUROPEAN PATENT APPLICATION**

(43) Date of publication:
**10.02.2021 Bulletin 2021/06**

(51) Int Cl.:
**G01R 15/14** *(2006.01)*    **G01R 19/00** *(2006.01)*

(21) Application number: **20189839.2**

(22) Date of filing: **06.08.2020**

<table>
<tr><td>

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.08.2019 EP 19190751**

(71) Applicant: **ABB Schweiz AG**
**5400 Baden (CH)**

</td><td>

(72) Inventors:
• **BOHNERT, Klaus**
  5452 Oberrohrdorf (CH)
• **GREMAUD, Robin**
  8048 Zürich (CH)

(74) Representative: **Vossius & Partner**
**Patentanwälte Rechtsanwälte mbB**
**Siebertstrasse 3**
**81675 München (DE)**

</td></tr>
</table>

(54) **VOLTAGE SENSING STRUCTURE**

(57)    The invention relates to a voltage sensing structure for a three-phase power line system, the voltage sensing structure comprising a first field sensor configured to sense an electric field at a first line of voltage, a second field sensor configured to sense an electric field at a second line of voltage, a third field sensor configured to sense an electric field at a third line of voltage, and at least one ground field sensor being configured to sense an electric field at a respective ground potential electrode, wherein the three-phase voltages are determined based on electric fields sensed by the first field sensor, the second field sensor, the third field sensor, and the at least one ground field sensor, and a plurality of sensitivity coefficients corresponding to electric field effects from each of the first line voltage, the second line voltage, and the third line voltage to each of the first field sensor, the second field sensor, the third field sensor and the at least one ground field sensor.

FIG. 1

EP 3 772 653 A1

**Description**

FIELD OF THE INVENTION

The invention relates to a voltage sensing structure for sensing a three-phase voltage of a high voltage electric power transmission system.

BACKGROUND OF THE INVENTION

Generally, power line alternating current (AC) voltages in electric power transmission and distribution grids are measured with inductive voltage transformers (VT) or capacitive voltage dividers (CVD). Particularly, resistive dividers or resistive/ capacitive dividers may be used when the power line AC voltages are lower. Due to their insulation requirements, the VT and CVD are relatively heavy, commonly oil-filled equipments, particularly at transmission voltages (typically when the power line AC voltages are in the range of hundreds of kilovolt). Other drawbacks of VT and CVD include the susceptibility to potentially hazardous ferro-resonances (VT) and limited accuracy at voltage transients.

Optical voltage transducers eliminate a number of the deficits of the conventional instruments of measuring the power line AC voltage. However, known optical voltage transducers for outdoor air-insulated systems (AIS) still comprise a voluminous insulator column, resulting in that the physical size of an optical voltage transducer is not much different from the one of conventional transformers, even though being of smaller weight and utilizing a gas insulation or dry insulation to replace the oil insulation.

Some recent works have focused on non-contact measurement of line voltages of the power lines. Some sensors are attempted to derive the line voltages by means of an array of generally capacitively coupled pick-up probes which may be located on the ground potential or are attached to the power lines. The measurement signals are transmitted from the power lines to the ground by optical fibers or wireless communications. This type of sensors offers ease of installation and robust high voltage insulation (without the need of an expensive insulator) but provide lower accuracy as the sensors are more susceptible to disturbances of the electric field distribution than conventional instruments. Also adjacent power lines may give rise to measurement uncertainties. Furthermore, the capacitive probes measure the time derivative of the electric field, and electric circuit parameters affect the frequency characteristic of the sensors.

DESCRIPTION OF THE INVENTION

These and other objectives are achieved by a voltage sensing structure according to the independent claims. Preferred embodiments are evident from the dependent patent claims.

The present invention relates to a voltage sensing structure for a three-phase power line system, the voltage sensing structure comprising a first field sensor configured to sense an electric field at a first line of voltage, a second field sensor configured to sense an electric field at a second line of voltage, a third field sensor configured to sense an electric field at a third line of voltage.

Various embodiments may preferably implement the following features:
Preferably, the three-phase voltages are determined based on the electric fields sensed by the first field sensor, the second field sensor and the third field sensor and a plurality of sensitivity coefficients corresponding to electric field effects from each of the first line voltage, the second line voltage, and the third line voltage to each of the first field sensor, the second field sensor and the third field sensor.

Preferably, the voltage sensing structure further comprises at least one ground field sensor being configured to sense an electric field at a respective ground potential electrode.

Preferably, the three-phase voltages are determined based on electric fields sensed by the first field sensor, the second field sensor, the third field sensor, and the at least one ground field sensor, and a plurality of sensitivity coefficients corresponding to electric field effects from each of the first line voltage, the second line voltage, and the third line voltage to each of the first field sensor, the second field sensor, the third field sensor and the at least one ground field sensor.

Preferably, the voltage sensing structure further comprises a first line voltage electrode, coupled to the first power line of voltage of the three-phase power line system, a second line voltage electrode, coupled to the second power line of voltage of the three-phase power line system, a third line voltage electrode, coupled to the third power line of voltage of the three-phase power line system.

Preferably, the first field sensor is coupled to the first line voltage electrode and is configured to sense the electric field at the first line voltage electrode, the second field sensor is coupled to the second line voltage electrode and is configured to sense the electric field at the second line voltage electrode, and the third field sensor is coupled to the third line voltage electrode and is configured to sense an electric field at the third line voltage electrode.

Preferably, the at least one ground field sensor is configured to employ an electro-optical effect to sense an electric field at the ground potential electrode.

Preferably, the first field sensor, the second field sensor and the third field sensor are optical field sensors.

Preferably, the first field sensor, the second field sensor and the third field sensor are preferably configured to employ an electro-optical effect to sense the electric fields at the first line voltage electrode, the second line voltage electrode and the third line voltage electrode.

Preferably, the first line voltage electrode is configured to steer the electric field in the vicinity of the first field sensor, the second line voltage electrode is configured to steer the electric field in the vicinity of the second field sensor, and the third line voltage electrode is configured to steer the electric in the vicinity of the third field sensor.

Preferably, the first line voltage electrode, the second line voltage electrode and the third line voltage electrode are disk shaped so as to perform the field steering.

Preferably, the at least one ground potential electrode is arranged at a first distance above the ground and the first line electrode, the second line voltage electrode and the third line voltage electrode are arranged at a second distance above the at least one ground potential electrode.

Preferably, the voltage sensing structure comprises three ground field sensors and three respective ground potential electrodes.

Preferably, each of the first line voltage electrode, the second line voltage electrode and the third line voltage electrode is connected to a respective ground potential electrode by an insulator tube containing at least one optical fiber of the respective field sensor coupled to the respectively connected line voltage electrode.

Preferably, the voltage sensing structure comprises at least one floating field sensor, configured between at least one of the first line voltage electrode, the second line voltage electrode, and the third line voltage electrode and at least one ground potential electrode.

Preferably, the three-phase voltages are determined based on electric fields sensed by the first field sensor, the second field sensor, the third field sensor, the at least one ground field sensor and the at least one floating field sensor, and a plurality of sensitivity coefficients corresponding to electric field effects from each of the first line voltage, the second line voltage, and the third line voltage to each of the first field sensor, the second field sensor, the third field sensor, the at least one ground potential sensor and the at least one floating field sensor.

Preferably, the at least one floating field sensor is configured in an insulator tube connected to one of the first line voltage electrode, the second line voltage electrode and the third line voltage electrode and one of the at least one ground potential electrode.

Preferably, the at least one ground potential electrode comprises a first ground potential electrode and a second ground potential electrode and the voltage sensing structure further comprising a plurality of ground field sensors.

Preferably, the plurality of ground field sensors comprises a first ground field sensor, coupled to the first ground potential electrode and configured to sense an electric field at the first ground potential electrode.

Preferably, the plurality of ground field sensors comprises a second ground field sensor, coupled to the second ground potential electrode and configured to sense an electric field at the second ground potential electrode.

Preferably, the three-phase voltages are determined based on the electric fields sensed by the first field sensor, the second field sensor, the third field sensor, the first ground field sensor and the second ground field sensor and a plurality of sensitivity coefficients corresponding to electric field effects from each of the first line voltage, the second line voltage, and the third line voltage to each of the first field sensor, the second field sensor, the third field sensor, the first ground field sensor and the second ground field sensor.

Preferably, the at least one ground potential electrode further comprises a third ground potential electrode and the plurality of ground field sensors further comprise a third ground field sensor, coupled to the third ground potential electrode and configured to sense an electric field at the third ground potential electrode.

Preferably, the three-phase voltages are determined based on the electric fields sensed by the first field sensor, the second field sensor, the third field sensor, the first ground field sensor, the second ground field sensor and the third ground field sensor and a plurality of sensitivity coefficients corresponding to electric field effects from each of the first line voltage, the second line voltage, and the third line voltage to each of the first field sensor, the second field sensor, the third field sensor, the first ground field sensor, the second ground field sensor and the third ground field sensor.

Preferably, the at least one ground potential electrode further comprises a fourth ground potential electrode and wherein the at least one ground field sensor further comprises a fourth ground field sensor, coupled to the fourth ground potential electrode and configured to sense an electric field at the fourth ground potential electrode.

Preferably, the three-phase voltages are determined based on electric fields sensed by the first field sensor, the second field sensor, the third field sensor, the first ground field sensor, the second ground field sensor, the third ground field sensor and the fourth ground field sensor and a plurality of sensitivity coefficients corresponding to electric field effects from each of the first line voltage, the second line voltage, the third line voltage to each of the first field sensor, the second field sensor, the third field sensor, the first ground field sensor, the second ground field sensor, the third ground field sensor and the fourth ground field sensor.

Preferably, the plurality of sensitivity coefficients are determined from the signals of the first field sensor, the second field sensor and the third field sensor when at least two of the first line voltage, the second line voltage and the third line voltage are at ground potential and the remaining of the first line voltage, the second line voltage and the third line voltage is a calibration voltage.

Preferably, the plurality of sensitivity coefficients is determined by electric field simulations.

Preferably, the three-phase voltages are three-phase voltages of a high voltage electric power transmission system.

The present invention also relates to a voltage sensing structure for a three-phase power line system, the voltage sensing structure comprising a first ground field sensor configured to sense an electric field at a first ground potential electrode coupled to the ground potential, a second ground field sensor configured to sense an electric field at a second ground potential electrode coupled to the ground potential, and a third ground field sensor configured to sense an electric field at a third ground potential electrode coupled to the ground potential, wherein the three-phases voltages are determined based on the electric fields sensed by the first ground field sensor, the second ground field sensor and the third ground field sensor and a plurality of sensitivity coefficients corresponding to electric field effects from each of a first line voltage of a three-phase voltage, the second line voltage of the three-phase voltage, the third line voltage of the three-phase voltage to each of the first ground field sensor, the second ground field sensor and the third ground field sensor.

Preferably, the first ground field sensor, the second ground field sensor and the third ground field sensor are optical field sensors.

Preferably, the first ground field sensor, the second ground field sensor and the third ground field sensor are configured to employ the electro-optical effect to sense the electric fields at the first ground potential electrode, the second ground potential electrode and the third ground potential electrode.

Preferably, the first ground potential electrode, the second ground potential electrode and the third ground potential electrode are arranged at a first distance above the ground and the first line voltage electrode, the second line voltage electrode and the third line voltage electrode are arranged at a second distance above the first ground potential electrode, the second ground potential electrode and the third ground potential electrode.

Preferably, the first line voltage electrode is connected to the first ground potential electrode by a first insulator tube, the second line voltage electrode is connected to the second ground potential electrode by a second insulator tube, and the third line voltage electrode is connected to the third ground potential electrode by a third insulator tube.

Preferably, the plurality of sensitivity coefficients are determined from the signals of the first ground field sensor, the second ground field sensor and the third ground field sensor when at least two of the first line voltage, the second line voltage and the third line voltage are at the ground level and the remaining of the first line voltage, the second line voltage and the third line voltage is a calibration voltage.

Preferably, the three-phase voltages constitute three-phase voltages of a high voltage electric power transmission system.

The present invention also relates to a method for voltage sensing at a three-phase power line system, the method comprising sensing an electric field at a first line of voltage with a first field sensor; sensing an electric field at a second line of voltage with a second field sensor; sensing an electric field at a third line of voltage with a third field sensor. The method preferably comprises determining the three-phase voltages based on the electric fields sensed by the first field sensor, the second field sensor and the third field sensor and a plurality of sensitivity coefficients corresponding to electric field effects from each of the first line voltage, the second line voltage, and the third voltage to each of the first field sensor, the second field sensor and the third field sensor.

The present invention also relates to a voltage sensing structure for a three-phase power line system, the voltage sensing structure comprising a first line voltage electrode, coupled to a first line of voltage, a second line voltage electrode coupled to a second line of voltage, a third line voltage electrode coupled to a third line of voltage of the three-phase voltages, a first ground potential electrode, coupled to the ground potential, a second ground potential electrode coupled to the ground potential, a third ground potential electrode, coupled to the ground potential, a first floating field sensor, configured between the first line voltage electrode and the first ground potential electrode, a second floating field sensor, configured between the second line voltage electrode and the second ground potential electrode, and a third floating field sensor configured between the third line voltage electrode and the third ground potential electrode, wherein the three-phase voltages are determined based on electric fields sensed by the first floating field sensor, the second floating field sensor and the third floating field sensor and a plurality of sensitivity coefficients corresponding to electric field effects from each of the first line voltage, the second line voltage, the third line voltage to each of the first floating field sensor, the second floating field sensor and the third floating field sensor.

Preferably, the first floating field sensor, the second floating field sensor and the third floating field sensor are optical field sensors.

Preferably, the first floating field sensor, the second floating field sensor and the third floating field sensor are configured to employ the electro-optical effect to sense the electric fields of determining the three-phase voltages.

Preferably, the first line voltage electrode, the second line voltage electrode, the third line voltage electrode, the first ground potential electrode, the second ground potential electrode and the third ground potential electrode are disk-shaped bodies facing each others.

Preferably, the plurality of sensitivity coefficients are determined from the signals of the first floating field sensor, the second floating field sensor and the third floating field sensor when at least two of the first line voltage, the second line voltage and the third line voltage are at the ground level and the remaining of the first line voltage, the second line voltage and the third line voltage is a calibration voltage.

BRIEF DESCRIPTION OF THE DRAWINGS

The subject matter of the invention will be explained in more detail in the following text with reference to preferred exemplary embodiments which are illustrated in the attached drawings, in which:

FIG. 1 schematically shows a voltage sensing structure according to an embodiment of the present disclosure.
FIG. 2 schematically shows sensitivity coefficients according to an embodiment of the present disclosure.
FIG. 3 schematically shows a voltage sensing structure according to an embodiment of the present disclosure.
FIG. 4 schematically shows sensitivity coefficients according to an embodiment of the present disclosure.
FIG. 5 schematically shows a voltage sensing structure according to an embodiment of the present disclosure.
FIG. 6 schematically shows a voltage sensing structure according to an embodiment of the present disclosure.
FIG. 7 schematically shows a table of a calibration process according to an embodiment of the present disclosure.
FIG. 8 schematically shows a configuration of mounting a field sensor on a line voltage electrode according to an embodiment of the present disclosure.
FIG. 9 schematically shows a configuration of mounting a ground field sensor on a ground potential electrode according to an embodiment of the present disclosure.
FIG. 10 schematically shows an arrangement of a field sensor and a corresponded ground field sensor according to an embodiment of the present disclosure.
FIG. 11 schematically shows a configuration of mounting the field sensor between two cylinder-shaped electrodes according to an embodiment of the present invention.

The reference symbols used in the drawings, and their primary meanings, are listed in summary form in the list of designations. In principle, identical parts are provided with the same reference symbols in the figures.

DETAILED DESCRIPTION OF PREFERRED EMBODIMENTS

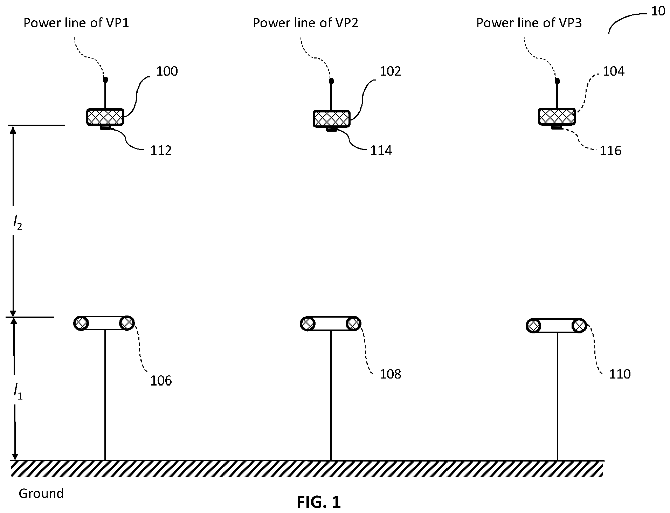

FIG. 1 relates to a voltage sensing structure 10 according to an embodiment of the present disclosure. The voltage sensing structure 10 is utilized to sense the three-phase voltages of a high voltage electric power transmission system. As shown in FIG. 1, the voltage sensing structure 10 comprises line voltage electrodes 100, 102, 104, ground potential electrodes 106, 108, 110 facing the line voltage electrodes 100, 102, 104, and field sensors 112, 114, 116. The line voltage electrodes 100, 102, and 104 are respectively coupled to power lines of line voltages VP1, VP2 and VP3. Here, the line voltages VP1, VP2, VP3 are defined as the voltages relative to ground. The ground potential electrodes 106, 108, and 110 (in electric contact with ground) are configured at a distance l1 above the ground and the line voltage electrodes 100, 102, and 104, are configured at a distance l2 above the ground potential electrodes 106, 108, 116. In an embodiment, the line voltage electrodes 100, 102, 104 and the ground potential electrodes 106, 108, 110 have disk-shaped bodies facing each others.

The field sensors 112, 114 and 116 are respectively coupled (e.g. ohmically coupled) to the line voltage electrodes 100, 102 and 104 and configured to sense electric fields respectively at the line voltage electrodes 100, 102 and 104. For example, the field sensor 112, 114, and 116 are configured to sense the electric fields at bottom sides of line voltage electrodes. Preferably, the field sensor 112, 114 and 116 are configured to sense the electric fields in a vertical direction (e.g. from the ground to each of the line electrodes 100, 102, and 104). In an embodiment, the field sensors 112, 114 and 116 are optical field sensors. For example, the field sensors 112, 114 and 116 are configured to employ the electro-optical effect to sense the electric fields at the line voltage electrode 100, 102, 104. Based on the electrode fields sensed by the field sensors 112, 114 and 116, a voltage determining device (not shown in FIG. 1) is able to determine the line voltages VP1, VP2 and VP3.

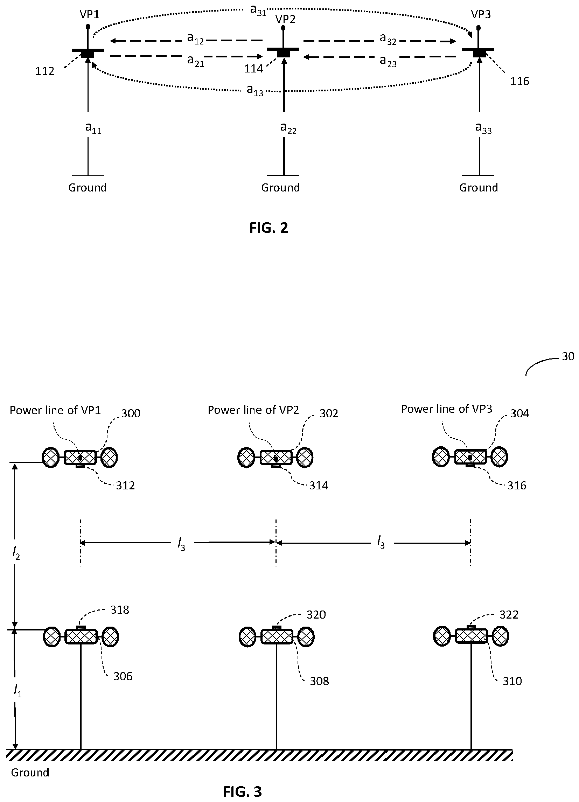

In detail, the line voltages VP1, VP2 and VP3 may be obtained according to the electrode fields sensed by the field sensors 112, 114 and 116 and a plurality of sensitivity coefficients $a_{ij}$ (where i= 1, 2, 3, j = 1, 2, 3) which are corresponding to electric field effects from each of the line voltages VP1, VP2, VP3 to each of the field sensors 112, 114 and 116. FIG. 2 relates to a schematic diagram of the sensitivity coefficients $a_{ij}$ according to an embodiment of the present disclosure. As shown in FIG. 2, the sensitivity coefficient $a_{11}$ is the electric field effect from the difference between line potential VP1 and ground potential (i.e. from line voltage VP1), $a_{12}$ is the electric field effect from the line voltage VP2 to the field sensor 112, $a_{13}$ is the electric field effect from the line voltage VP3 to the field sensor 112, and so on. Based on FIG. 2, instantaneous values of the output signals $S_1$, $S_2$ and $S_3$ of the field sensors 112, 114 and 116 at a time t can be expressed as:

$$\begin{pmatrix} S_1 \\ S_2 \\ S_3 \end{pmatrix} = \begin{pmatrix} a_{11} & a_{12} & a_{13} \\ a_{21} & a_{22} & a_{23} \\ a_{31} & a_{32} & a_{33} \end{pmatrix} \begin{pmatrix} V_1 \\ V_2 \\ V_3 \end{pmatrix} \qquad (1)$$

or

$$\begin{pmatrix} S_1 \\ S_2 \\ S_3 \end{pmatrix} = A \begin{pmatrix} V_1 \\ V_2 \\ V_3 \end{pmatrix} \qquad (2)$$

where matrix A is given as

$$A = \begin{pmatrix} a_{11} & a_{12} & a_{13} \\ a_{21} & a_{22} & a_{23} \\ a_{31} & a_{32} & a_{33} \end{pmatrix} \qquad (3)$$

where $V_1$, $V_2$ and $V_3$ are instantaneous values of the line voltages VP1, VP2 and VP3 at the time t. The sensitivity coefficients $a_{ij}$ depend on relative positions of the line voltage electrodes 100, 102, 104 and the ground potential electrodes 106, 108, 110, shapes of the line voltage electrodes 100, 102, 104 and a permittivity $\varepsilon$ of the environment (the permittivity $\varepsilon$ is assumed as unity in this embodiment). Based on the equations (1) to (3), the voltage $V_1$, $V_2$ and $V_3$ can be obtained from the signals $S_1$, $S_2$ and $S_3$ as:

$$\begin{pmatrix} V_1 \\ V_2 \\ V_3 \end{pmatrix} = A^{-1} \begin{pmatrix} S_1 \\ S_2 \\ S_3 \end{pmatrix} \qquad (4)$$

where matrix $A^{-1}$ is the inverse matrix of the matrix A and can be expressed as:

$$A^{-1} = \frac{1}{\det(A)} \begin{pmatrix} a_{22}a_{33} - a_{23}a_{32} & a_{13}a_{32} - a_{12}a_{33} & a_{12}a_{23} - a_{13}a_{22} \\ a_{23}a_{31} - a_{21}a_{33} & a_{11}a_{33} - a_{13}a_{31} & a_{13}a_{21} - a_{11}a_{23} \\ a_{21}a_{32} - a_{22}a_{31} & a_{12}a_{31} - a_{11}a_{32} & a_{11}a_{22} - a_{12}a_{21} \end{pmatrix} \qquad (5)$$

and the determinant det(A) is given as:

$$\det(A) = a_{11}a_{22}a_{33} + a_{12}a_{23}a_{31} + a_{13}a_{21}a_{32}$$
$$-a_{13}a_{22}a_{31} - a_{11}a_{23}a_{32} - a_{12}a_{21}a_{33} \qquad (6)$$

The sensitivity coefficients $a_{ij}$ may be determined by a calibration process or by electric field simulations.

In an embodiment, the field sensors 112, 114 and 116 may change to be configured on the ground potential electrodes 106, 108 and 110 and are configured to sense electric fields at the ground potential electrodes 106, 108 and 110, respectively. The line voltages VP1, VP2 and VP3 also change to be determined based on the electric fields sensed by the field sensors 112, 114 and 116 configured on the ground potential electrodes 106, 108 and 110 according to the equations (1) to (6).

Note that, the number of the ground potential electrodes varies based on different design concepts and requirements and even can be zero, i.e., ground itself becomes the common "electrode" for all three power lines. In an embodiment, each of the field sensors mounted on the line voltage electrodes has 3 corresponding ground field sensors mounted on ground potential electrodes, wherein the 3 ground field sensors corresponding to the same field sensor are positioned respectively at 3 vertexes of an equilateral horizontal triangle whose center is beneath the corresponding field sensor.

FIG. 3 relates to a voltage sensing structure 30 according to an embodiment of the present disclosure. In comparison with the voltage sensing structure 10, the voltage sensing structure 30 increases the number of field sensors to compensate changes in the relative positions among the field sensors and to maintain accuracy of the voltage sensing.

In detail, the voltage sensing structure 30 comprises line voltage electrodes 300, 302, 304, ground potential electrodes 306, 308, 310 facing the line voltage electrodes 300, 302, 304, field sensors 312, 314, 316, and ground field sensors 318, 320, 322. The line voltage electrodes 300, 302, 304, the ground potential electrodes 306, 308, 310 and the field sensors 312, 314, 316 are similar to the line voltage electrodes 100, 102, 104, the ground potential electrodes 106, 108, 110 and the field sensors 112, 114, 116 shown in FIG. 1. In FIG. 3, the line voltage electrodes 300, 302, 304 and the ground potential electrodes 306, 308, 310 are equipped with corona rings for field steering. In addition, the ground potential electrodes 306, 308 and 310 are arranged at the distance l1 above the ground, the line voltage electrodes 300, 302 and 304 are arranged at the distance l2 above the ground potential electrodes 306, 308 and 310, and the line voltage electrodes 300, 302, 304 and the ground potential electrodes 306, 308, 310 are horizontally arranged with an interval 13.

In this embodiment, three additional ground field sensors 318, 320 and 322 are configured on the ground potential electrodes 306, 308 and 310 and configured to sense electric fields at the ground potential electrodes 306, 308 and 310. The line voltages VP1, VP2 and VP3 of the three-phase voltages are determined based on the electric fields sensed by the field sensors 312, 314, 316 and the ground field sensors 318, 320, 322 and sensitivity coefficients corresponding to electric field effects from each of the line voltages VP1, VP2, VP3 to each of the field sensors 312, 314, 316 and the ground field sensors 318, 320, 322.

Practically, the distances between each two field sensors may change due to, e.g., thermal expansion of mechanical structures for mounting the field sensors 312, 314, 316 and the ground field sensors 318, 320, 322 or forces (e.g. from wind) acting on the assembly. The using of more than 3 sensors as the voltage sensing structure 30 makes it possible to distinguish between signal changes caused by changes in the line voltages VP1, VP2 and VP3 from those caused by changes in sensor arrangement.

For example, if the line voltage VP1 changes and all distances between each two of the field sensors 312, 314, 316 and the ground field sensors 318, 320, 322 remain the same, the output signals of the field sensor 312 and the ground field sensor 318 will both change in proportion to the line voltage VP1. That is, the ratio between the output signals of the field sensor 312 and the ground field sensor 318 will remain unchanged. On the other hand, if the line voltages VP1, VP2 and VP3 stay constant but the distance between the field sensor 312 and the ground field sensor 318 changes, the ratio of output signals of the field sensor 312 and the ground field sensor 318 will change. In an example assuming the electric field around the power lines of line voltage VP1, VP2 and VP3 are cylinder-symmetric electric fields, which fall off inversely proportional to the distance from the line, the ratio between the output signals of the field sensor 312 and the ground field sensor 318 changes in an inverse proportion to the distance between the field sensor 312 and the ground field sensor 318 (the position of field sensor 312 relative to the centers of the power lines remains unchanged in this example). In a similar manner, changes in the lateral distances among the field sensors 312, 314 and 316 can be accounted for from changes in ratios among the output signals of the field sensors 312, 314, 316.

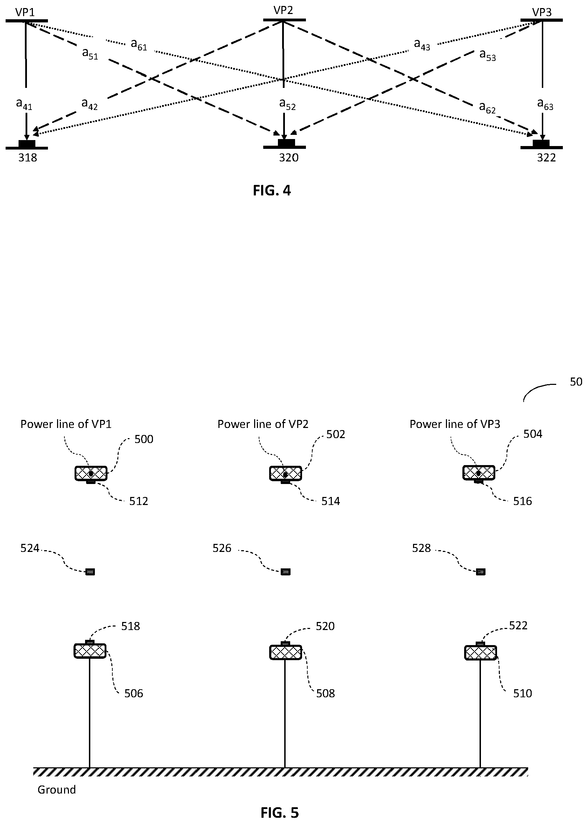

Details of utilizing the output signals $S_1$, $S_2$, $S_3$ of the field sensors 312, 314 and 316 to determine instantaneous values $V_1$, $V_2$ and $V_3$ of the line voltages VP1, VP2 and VP3 can be referred to FIG. 2, the equations (1) to (5) and related descriptions and are not described herein for brevity. FIG. 4 relates to schematic diagram of sensitivity coefficients $a_{ij}$ corresponding to the ground field sensors 318, 320 and 322 according to an embodiment of the present disclosure. Based on the equations (2) to (6), output signals $S_4$, $S_5$ and $S_6$ of the ground field sensors 318, 320 and 322 can be expressed as:

$$\begin{pmatrix} S_4 \\ S_5 \\ S_3 \end{pmatrix} = A' \begin{pmatrix} V_1 \\ V_2 \\ V_3 \end{pmatrix} \qquad (7)$$

where $V_1$, $V_2$ and $V_3$ are instantaneous values of the line voltages VP1, VP2 and VP3 and matrix A' is given as

$$A' = \begin{pmatrix} a_{41} & a_{41} & a_{43} \\ a_{51} & a_{52} & a_{53} \\ a_{61} & a_{62} & a_{63} \end{pmatrix} \qquad (8)$$

According to equations (7) and (8), the instantaneous values $V_1$, $V_2$ and $V_3$ of the line voltages VP1, VP2 and VP3 can be determined by:

$$\begin{pmatrix} V_1 \\ V_2 \\ V_3 \end{pmatrix} = A'^{-1} \begin{pmatrix} S_4 \\ S_5 \\ S_6 \end{pmatrix} \tag{9}$$

where matrix $A'^{-1}$ is the inverse matrix of the matrix A' and can be expressed as:

$$A'^{-1} = \frac{1}{\det(A')} \begin{pmatrix} a_{52}a_{63} - a_{53}a_{62} & a_{43}a_{62} - a_{42}a_{63} & a_{42}a_{53} - a_{43}a_{52} \\ a_{53}a_{61} - a_{51}a_{63} & a_{41}a_{63} - a_{43}a_{61} & a_{43}a_{51} - a_{41}a_{53} \\ a_{51}a_{62} - a_{52}a_{61} & a_{42}a_{61} - a_{41}a_{62} & a_{41}a_{52} - a_{42}a_{51} \end{pmatrix} \tag{10}$$

and the determinant det(A') is given as:

$$\det(A') = a_{41}a_{52}a_{63} + a_{42}a_{53}a_{61} + a_{43}a_{51}a_{62}$$

$$- a_{43}a_{52}a_{61} - a_{41}a_{53}a_{62} - a_{42}a_{51}a_{63} \tag{11}$$

According to the equations (4) to (6) and (9) to (11), the three instantaneous values $V_1$, $V_2$ and $V_3$ of the line voltages VP1, VP2 and VP3 are derived from the output signals $S_1$ to $S_6$ of the field sensors 312, 314, 316 and the ground field sensors 318, 320, 322 and 18 sensitivity coefficients $a_{ij}$ (i=1 to 6 and j=1 to 3), where the signals $S_1$ to $S_6$ may vary with time as a result of changing relative positions among the field sensors 312, 314, 316 and the ground field sensors 318, 320, and 322. Some of the sensitivity coefficients $a_{ij}$ (i=1 to 6 and j=1 to 3) may be dependent on other sensitivity coefficients and can be expressed by corresponded sensitivity coefficients so as to reduce the number of independent variables in the equations (4) to (6) and (9) to (11). In an embodiment of assuming the lateral positions of the ground potential electrodes 306, 308 and 310 remain stable, the lateral positions of the line voltage electrodes 300, 302 and 304 may vary and the vertical separations between the line voltage electrodes 300, 302, and 304 and the ground potential electrodes 306, 308 and 310 (i.e. the distances 12) may change by the same fraction, the sensitivity coefficients $a_{ij}$ (i=1 to 6 and j=1 to 3) can expressed by the sensitivity coefficients $a_{22}$, $a_{12}$ and $a_{32}$ and fixed constant coefficients $\alpha_k$, k= 0, 1, 2, ..., 6 which can be acquired by a calibration process or field simulations:

$$a_{11} = \alpha_2 a_{22}$$

$$a_{33} = \alpha_2 a_{22}$$

$$a_{52} = \alpha_0 a_{22}$$

$$a_{41} = \alpha_1 a_{11}$$

$$a_{63} = \alpha_1 a_{33}$$

$$a_{21} = \alpha_3 a_{12}$$

$$a_{23} = \alpha_3 a_{32}$$

$$a_{13} = \alpha_4(a_{12} + a_{32})$$

$$a_{31} = \alpha_4(a_{12} + a_{32})$$

$$a_{51} = \alpha_5 a_{20} + \cdots$$

$$a_{42} = \alpha_5 a_{20} + \cdots$$

$$a_{53} = \alpha_5 a_{20} + \cdots$$

$$a_{62} = \alpha_5 a_{20} + \cdots$$

$$a_{61} = \alpha_6 a_{20} + \cdots$$

$$a_{43} = \alpha_5 a_{20} + \cdots$$

Note that only changes in the coefficient $a_{20}$ are taken into account to recalculate the less critical sensitivity coefficients $a_{51}$, $a_{42}$, $a_{53}$, $a_{62}$, $a_{61}$ and $a_{43}$ (corresponding to diagonal dashed lines in FIG. 4) which describe the effects of the respective adjacent line voltages on the ground field sensors 318, 320 and 322 at the ground potential. That is, variations in the lateral positions of the line voltage electrodes are neglected when recalculating the sensitivity coefficients $a_{51}$, $a_{42}$, $a_{53}$, $a_{62}$, $a_{61}$ and $a_{43}$.

In order to enhance a robustness of a voltage sensing structure, additional sensors may be added at appropriate positions in the voltage sensing structure of the present disclosure. In an embodiment, at least one floating field sensor may be configured between at least one of line voltage electrodes (e.g. 300, 302 and 304) and corresponded ground potential electrode (e.g. 306, 308 or 310). FIG. 5 relates to a voltage sensing structure 50 according to an embodiment of the present disclosure. In comparison with the voltage sensing structure 30, the voltage sensing structure 50 adds floating field sensors 524, 526 and 528 which are configured respectively between the line electrode 500 and the ground potential electrode 506, between the line electrode 502 and the ground potential electrode 508 and between the line electrode 504 and the ground potential electrode 510. In this embodiment, each of the floating field sensors 524, 526 and 528 are configured at a halfway position between the corresponding line voltage electrode and the ground potential electrode. The line voltages VP1, VP2 and VP3 of the three-phase voltages are determined according to the electric fields sensed by the field sensors 512, 514, 516, the ground field sensors 518, 520, 522 and the floating field sensors 524, 526, 528 and the sensitivity coefficients corresponding to electric field effects from each of the line voltages VP1, VP2, VP3 and each of the line voltages VP1, VP2 and VP3 of the three-phase voltages are determined according to the electric fields sensed by the field sensors 512, 514, 516, the ground field sensors 518, 520, 522 and the floating field sensors 524, 526, 528.

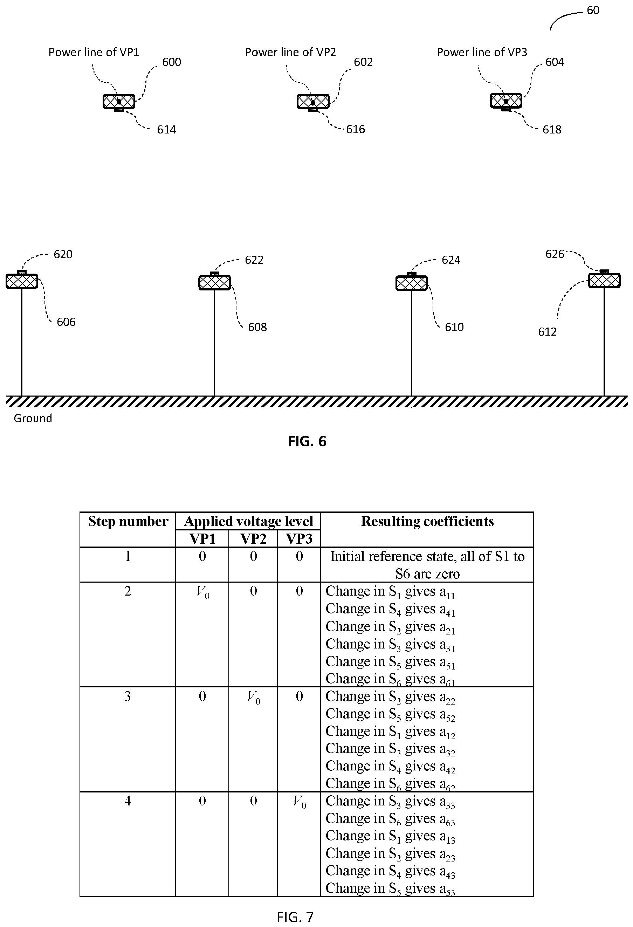

FIG. 6 relates to a voltage sensing structure 60 according to an embodiment of the present disclosure. In this embodiment, the number of the ground potential electrodes increases from 3 to 4. As shown in FIG. 6, the voltage sensing structure 60 comprises high voltage electrodes 600, 602, 604, ground potential electrodes 606, 608, 610, 612, field sensors 614, 616, 618 mounted on the high voltage electrodes 600, 602 604 and the ground field sensors 620, 622, 624, 626 mounted on the ground potential electrodes 606, 608, 610, 612. The ground field sensors 620, 622, 624, 626 are horizontally displaced from the field sensors 614, 616 and 618 by half the lateral distance between the field sensors 614, 616 or the field sensors 616, 618. The line voltages VP1, VP2 and VP3 of the three-phase voltages are determined based on the electric fields sensed by the field sensors 614, 616, 618 and the ground field sensors 620, 622, 624, 626 and sensitivity coefficients corresponding to electric field effects from each of the line voltages VP1, VP2, VP3 to each of the field sensors 614, 616, 618 and the ground field sensors 620, 622, 624, 626. The arrangement shown in FIG. 6 is able to compensate an individual horizontal movement of each of the field sensors 614, 616 and 618.

In an embodiment, the ground potential electrodes 606 and 612 and the ground field sensors 620 and 626 on the ground potential electrodes 606 and 612 may be omitted. That is, the voltage sensing structure 60 may change to have 2 ground electrodes 608 and 610, which are configured between the line voltage electrodes 600 and 602 and between the line voltage electrodes 602 and 604, and the corresponding ground field sensors 622 and 624.

FIG. 7 relates to a table of a calibration process according to an embodiment of the present disclosure. The calibration process shown in FIG. 7 is utilized to determine the sensitivity coefficients $a_{ij}$ (i= 1, 2, 3, ... , 6 and j = 1, 2, 3) shown in FIG. 2 and FIG. 4. According to the table shown in FIG. 7, all of the line voltages VP1, VP2 and VP3 are set to 0 (i.e. the ground potential) and the output signals S1 to S6 of the field sensors (e.g. 312, 314 and 316) and the ground field sensors (e.g. 318, 320 and 322) are acquired as initial reference states at which all of the output signals $S_1$ to $S_6$ are zero. Next, the line voltages VP1, VP2 and VP3 are sequentially set to a voltage potential $V_0$ which is a calibration voltage with amplitude $V_0$ while leaving remaining two line voltages on the ground potential. When the line voltage VP1 is set to the voltage potential V0 and the line voltages VP2 and VP3 are on the ground potential, a change in the output signal $S_1$ with respect to that of initial reference state acquired in the step 1 is acquired as the sensitivity coefficient $a_{11}$, a change in the output signal $S_4$ with respect to that of initial reference state is acquired as the sensitivity coefficient $a_{41}$, a change in the output signal $S_2$ with respect to that of initial reference state is acquired as the sensitivity coefficient $a_{21}$, and so on. Similarly, when the line voltage VP2 is set to the voltage potential $V_0$ and the line voltages VP1 and VP3 are set to the ground potential, a change in the output signal $S_2$ with respect to that of initial reference state acquired in the step 1 is acquired as the sensitivity coefficient $a_{22}$, a change in the output signal $S_5$ with respect to that of initial reference state is acquired as the sensitivity coefficient $a_{52}$, a change in the output signal $S_1$ with respect to that of initial reference state is acquired as the sensitivity coefficient $a_{12}$, and so on. In addition, when the line voltage VP3 is set to the voltage potential $V_0$ and the line voltages VP1 and VP2 are set to the ground potential, a change in the output signal $S_3$ with respect to that of initial reference state acquired in the step 1 is acquired as the sensitivity coefficient $a_{33}$, a change in the output signal $S_6$ with respect to that of initial reference state is acquired as the sensitivity coefficient $a_{63}$, a change in the output signal $S_1$ with respect to that of initial reference state is acquired as the sensitivity coefficient $a_{13}$, and so on.

Furthermore, when all of the sensitivity coefficients $a_{ij}$ (i = 1, 2, 3, ... , 6 and j = 1, 2, 3) are determined, the fixed constant coefficients $\alpha_k$ (k= 0, 1, 2, 3, ... , 6) also can be determined.

In an embodiment, the calibration process shown in FIG. 7 may be implemented in an automated way.

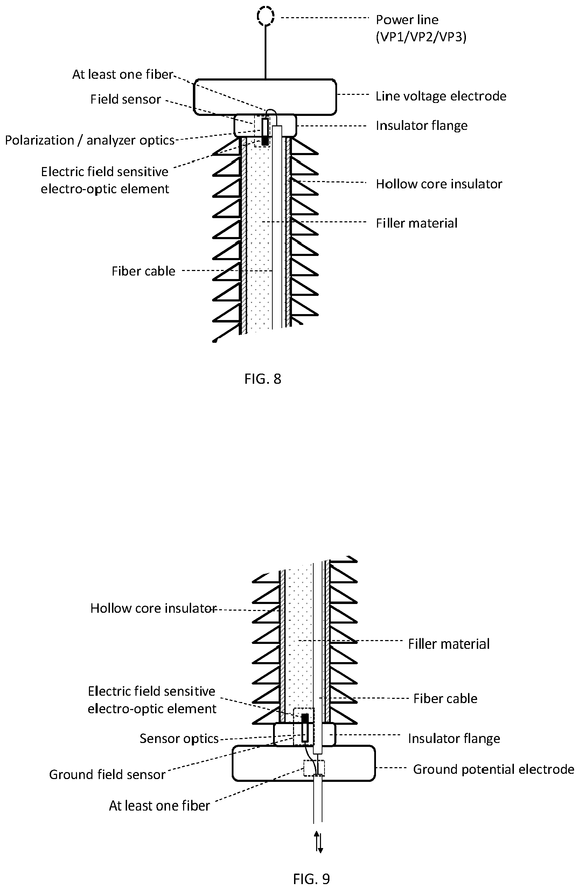

FIGS. 8 and 9 relate to configurations of mounting a field sensor on a line voltage electrode and a ground field sensor on a ground potential electrode according to an embodiment of the present disclosure. As shown in FIGS. 8 and 9, the line voltage electrode and the ground potential electrode are connected by hollow core insulator (e.g. an insulator tube).

In this embodiment, the field sensor and the ground field sensor may be electro-optic field sensors, which consist of an electric field sensitive electro-optic element and sensor optics which may comprise polarizers, waveplates, beam splitters and collimators. The fiber cable comprises at least one optical fiber but may also consist of several fibers that carry light to and from a particular sensor. The line voltage electrode and ground potential electrode are attached to insulator flanges of a hollow core insulator. The field sensor and the ground field sensor are mounted in the insulator flanges (or the line voltage electrodes and the ground potential electrode). The electric field sensitive elements of the field sensor and the ground field sensor protrude into the electric fields at the outer surface of the insulator flanges. The remaining sensor optics are inside the insulator flanges. A fiber cable connects an opto-electronic unit (including a light source, photodetectors, and signal processing electronics, not shown in FIGS. 8 and 9) to the field sensor and the ground field sensor. In FIG. 9, the fiber cable enters the ground potential electrode from below. The fibers of the ground field sensor are split off from the cable within a fiber splice or connector box (not shown). The other fibers continue in a subsequent cable section through the hollow insulator to the line voltage electrode and the corresponding field sensor. Alternatively, the fibers passing through the hollow core insulator are not in a fiber cable but are bare fibers with only a primary coating or a buffer coating. The hollow volume of the hollow core insulator is filled with a high voltage proof filler material, e.g., compressible polyurethane foam or silicone gel. Another alternative is an insulating gas such as dry nitrogen.

In FIGS. 8 and 9, the field sensor and the ground field sensor protrude into the hollow core insulator. Alternatively, the insulator may be laterally displaced so that the field sensor and the ground field sensor protrude into environmental air.

In an embodiment, the field sensor and the ground field sensor shown in FIGS. 8 and 9 may change to other types of electric field sensor. For example, the field sensor and the ground field sensor shown in FIGS. 8 and 9 may utilize piezoelectric transducer materials with optical interrogation to sense the electric fields at the line voltage electrode and the ground potential electrode.

In an embodiment, at least one floating field sensor may be configured into the hollow core insulator (e.g. an insulator tube) connecting the line voltage electrode and the ground potential electrode shown in FIGS. 8 and 9. For example, the floating field sensor 524 may be configured to the insulator tube connecting the line voltage electrode 500 and the ground potential electrode 506. Similarly, the floating field sensor 526 may be configured to the insulator tube connecting the line voltage electrode 502 and the ground potential electrode 508, and the floating field sensor 526 may be configured to the insulator tube connecting the line voltage electrode 504 and the ground potential electrode 510.

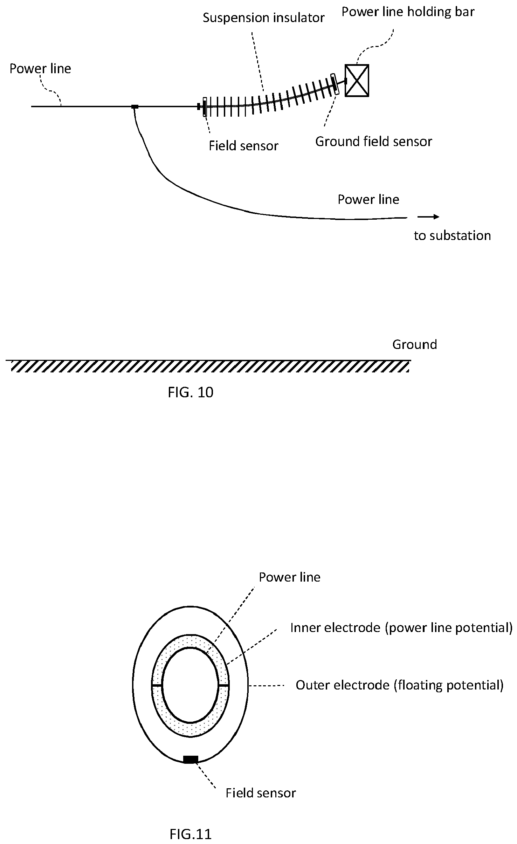

FIG. 10 relates to an arrangement of a field sensor and a corresponded ground field sensor according to an embodiment of the present disclosure. In FIG. 10, the field sensor and the corresponded ground field sensor (e.g. the field sensor 312 and the ground field sensor 318) are mounted at two ends of a (flexible or rigid) suspension insulator that holds the corresponding power line, e.g., at a location where the line enters into a substation. The suspension insulator carries the fiber connection to the sensor on the high voltage side of the insulator.

FIG. 11 relates to a configuration of mounting the field sensor between two cylinder-shaped electrodes according to an embodiment of the present invention. In FIG. 11, the cylinder shaped electrodes are concentric with a power line of corresponding line voltage. The inner electrode is electrically contact with the power line and thus has the same potential as the power line. The outer electrode is on a floating potential. The field sensor measures the electric field between the inner electrode and the outer electrode, e.g., at the inner surface of the outer electrode. The arrangement shown in FIG. 11 may be designed as a "clamp-on mount" that can be attached to the power line without interrupting the power line. As a result, the field sensor can be well protected from the environment. The same or a similar arrangement may also be chosen for the ground field sensors. The inner electrode is then set to the ground potential.

Note that, the inner electrode in FIG. 11 may be omitted. That is, the powerline represents the inner electrode.

LIST OF REFERENCE NUMBERS

**[0078]**

10, 30, 50, 60
Voltage sensing structure

100, 102, 104, 300, 302, 304, 500, 502, 504, 600, 602, 604
Line voltage electrodes

106, 108, 110, 306, 308, 310, 506, 508, 510, 606, 608, 610, 612
Ground potential electrodes

112, 114, 116, 312, 314, 316, 614, 616, 618
Field sensors

318, 320, 322, 518, 520, 522, 620, 622, 624, 626
Ground field sensors

524, 526, 528
Floating field sensors

VP1, VP2, VP3
Line voltages

**Claims**

1.  A voltage sensing structure for a three-phase power line system, comprising:

    a first field sensor (112) configured to sense an electric field at a first line of voltage (VP1),
    a second field sensor (114) configured to sense an electric field at a second line of voltage (VP2),
    a third field sensor (116) configured to sense an electric field at a third line of voltage (VP3), and
    at least one ground field sensor being configured to sense an electric field at a respective ground potential electrode,
    wherein the three-phase voltages (VP1, VP2, VP3) are determined based on electric fields sensed by the first field sensor (312), the second field sensor (314), the third field sensor (316), and the at least one ground field sensor, and a plurality of sensitivity coefficients corresponding to electric field effects from each of the first line voltage (VP1), the second line voltage (VP2), and the third line voltage (VP3) to each of the first field sensor (312), the second field sensor (314), the third field sensor (316) and the at least one ground field sensor.

2.  The voltage sensing structure of claim 1, further comprising:

    a first line voltage electrode (100), coupled to the first power line of voltage (VP1) of the three-phase power line system,
    a second line voltage electrode (102), coupled to the second power line of voltage (VP2) of the three-phase power line system,

a third line voltage electrode (104), coupled to the third power line of voltage (VP3) of the three-phase power line system,

wherein the first field sensor (112) is coupled to the first line voltage electrode and is configured to sense the electric field at the first line voltage electrode (100), the second field sensor (114) is coupled to the second line voltage electrode and is configured to sense the electric field at the second line voltage electrode (102), and the third field sensor (116) is coupled to the third line voltage electrode and is configured to sense an electric field at the third line voltage electrode (104).

3. The voltage sensing structure of claim 1 or 2, wherein the at least one ground field sensor being configured to employ an electro-optical effect to sense an electric field at the ground potential electrode.

4. The voltage sensing structure of claim 2 or 3, wherein the first field sensor (112), the second field sensor (114) and the third field sensor (116) are optical field sensors and wherein the first field sensor (112), the second field sensor (114) and the third field sensor (116) are preferably configured to employ an electro-optical effect to sense the electric fields at the first line voltage electrode (100), the second line voltage electrode (102) and the third line voltage electrode (104).

5. The voltage sensing structure of any one of claims 2 to 4, wherein the first line voltage electrode (100) is configured to steer the electric field in the vicinity of the first field sensor (112), the second line voltage electrode (102) is configured to steer the electric field in the vicinity of the second field sensor (114), and the third line voltage electrode (104) is configured to steer the electric in the vicinity of the third field sensor (116) and/or

wherein the first line voltage electrode (100), the second line voltage electrode (102) and the third line voltage electrode (104) are disk shaped so as to perform the field steering.

6. The voltage sensing structure of any of claims 1 to 5, wherein the at least one ground potential electrode is arranged at a first distance (11) above the ground and the first line electrode (100), the second line voltage electrode (102) and the third line voltage electrode (104) are arranged at a second distance (12) above the at least one ground potential electrode.

7. The voltage sensing structure of any of claims 1 to 6, comprising three ground field sensors and three respective ground potential electrodes, wherein preferably each of the first line voltage electrode (100), the second line voltage electrode (102) and the third line voltage electrode (104) is connected to a respective ground potential electrode by an insulator tube containing at least one optical fiber of the respective field sensor coupled to the respectively connected line voltage electrode.

8. The voltage sensing structure of any of claims 2 to 7, further comprising:

at least one floating field sensor, configured between at least one of the first line voltage electrode (100), the second line voltage electrode (102), and the third line voltage electrode (104) and at least one ground potential electrode,

wherein the three-phase voltages are determined based on electric fields sensed by the first field sensor (512), the second field sensor (514), the third field sensor (516), the at least one ground field sensor and the at least one floating field sensor, and a plurality of sensitivity coefficients corresponding to electric field effects from each of the first line voltage (VP1), the second line voltage (VP2), and the third line voltage (VP3) to each of the first field sensor (512), the second field sensor (514), the third field sensor (516), the at least one ground potential sensor and the at least one floating field sensor.

9. The voltage sensing structure of claim 8, wherein the at least one floating field sensor is configured in an insulator tube connected to one of the first line voltage electrode (100), the second line voltage electrode (102) and the third line voltage electrode (104) and one of the at least one ground potential electrode.

10. The voltage sensing structure of any of claims 1 to 9, wherein the plurality of sensitivity coefficients are determined from the signals of the first field sensor (112), the second field sensor (114) and the third field sensor (116) when at least two of the first line voltage (VP1), the second line voltage (VP2) and the third line voltage (VP3) are at ground potential and the remaining of the first line voltage (VP1), the second line voltage (VP2) and the third line voltage (VP3) is a calibration voltage.

11. The voltage sensing structure of any of claims 1 to 10, wherein the plurality of sensitivity coefficients is determined by electric field simulations.

**12.** The voltage sensing structure of any of claims 1 to 11, wherein the three-phase voltages are three-phase voltages of a high voltage electric power transmission system.

**13.** A voltage sensing structure for a three-phase power line system comprising:

a first ground field sensor configured to sense an electric field at a first ground potential electrode (106) coupled to the ground potential,
a second ground field sensor configured to sense an electric field at a second ground potential electrode (108) coupled to the ground potential, and
a third ground field sensor configured to sense an electric field at a third ground potential electrode (110) coupled to the ground potential,
wherein the three-phases voltages (VP1, VP2, VP3) are determined based on the electric fields sensed by the first ground field sensor, the second ground field sensor and the third ground field sensor and a plurality of sensitivity coefficients corresponding to electric field effects from each of a first line voltage (VP1) of three-phase voltages, the second line voltage (VP2) of three-phase voltages, the third line voltage (VP3) of three-phase voltages to each of the first ground field sensor, the second ground field sensor and the third ground field sensor.

**14.** A method for voltage sensing at a three-phase power line system, comprising:

sensing an electric field at a first line of voltage (VP1) with a first field sensor (112);
sensing an electric field at a second line of voltage (VP2) with a second field sensor (114);
sensing an electric field at a third line of voltage (VP3) with a third field sensor (116);
sensing an electric field at a ground potential electrode with at least one ground field sensor
determining the three-phase voltages (VP1, VP2, VP3) based on electric fields sensed by the first field sensor (312), the second field sensor (314), the third field sensor (316), and the at least one ground field sensor, and
a plurality of sensitivity coefficients corresponding to electric field effects from each of the first line voltage (VP1), the second line voltage (VP2), and the third line voltage (VP3) to each of the first field sensor (312), the second field sensor (314), the third field sensor (316) and the at least one ground field sensor.

Power line of VP1

Power line of VP2

Power line of VP3

10

100

102

104

112

114

116

$l_2$

106

108

110

$l_1$

Ground

**FIG. 1**

**FIG. 2**

**FIG. 3**

VP1    VP2    VP3

$a_{51}$    $a_{61}$    $a_{43}$    $a_{53}$

$a_{41}$    $a_{42}$    $a_{52}$    $a_{62}$    $a_{63}$

318    320    322

**FIG. 4**

50

Power line of VP1    Power line of VP2    Power line of VP3

500    502    504

512    514    516

524    526    528

518    520    522

506    508    510

Ground

**FIG. 5**

Power line of VP1  600
Power line of VP2  602
Power line of VP3  604

60

614
616
618

620
622
624
626

606
608
610
612

Ground

FIG. 6

| Step number | Applied voltage level | | | Resulting coefficients |
|---|---|---|---|---|
| | VP1 | VP2 | VP3 | |
| 1 | 0 | 0 | 0 | Initial reference state, all of S1 to S6 are zero |
| 2 | $V_0$ | 0 | 0 | Change in $S_1$ gives $a_{11}$<br>Change in $S_4$ gives $a_{41}$<br>Change in $S_2$ gives $a_{21}$<br>Change in $S_3$ gives $a_{31}$<br>Change in $S_5$ gives $a_{51}$<br>Change in $S_6$ gives $a_{61}$ |
| 3 | 0 | $V_0$ | 0 | Change in $S_2$ gives $a_{22}$<br>Change in $S_5$ gives $a_{52}$<br>Change in $S_1$ gives $a_{12}$<br>Change in $S_3$ gives $a_{32}$<br>Change in $S_4$ gives $a_{42}$<br>Change in $S_6$ gives $a_{62}$ |
| 4 | 0 | 0 | $V_0$ | Change in $S_3$ gives $a_{33}$<br>Change in $S_6$ gives $a_{63}$<br>Change in $S_1$ gives $a_{13}$<br>Change in $S_2$ gives $a_{23}$<br>Change in $S_4$ gives $a_{43}$<br>Change in $S_5$ gives $a_{53}$ |

FIG. 7

At least one fiber

Field sensor

Polarization / analyzer optics

Electric field sensitive
electro-optic element

Fiber cable

Power line
(VP1/VP2/VP3)

Line voltage electrode

Insulator flange

Hollow core insulator

Filler material

FIG. 8

Hollow core insulator

Electric field sensitive
electro-optic element

Sensor optics

Ground field sensor

At least one fiber

Filler material

Fiber cable

Insulator flange

Ground potential electrode

FIG. 9

Suspension insulator    Power line holding bar

Power line

Field sensor    Ground field sensor

Power line

to substation

Ground

FIG. 10

Power line

Inner electrode (power line potential)

Outer electrode (floating potential)

Field sensor

FIG.11

Europäisches
Patentamt

European
Patent Office

Office européen
des brevets

# EUROPEAN SEARCH REPORT

Application Number

EP 20 18 9839

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 337 265 A1 (REINHAUSEN MASCHF SCHEUBECK [DE]) 18 October 1989 (1989-10-18) * the whole document * | 1-14 | INV. G01R15/14 G01R19/00 |
| X | US 2005/286190 A1 (ROSTRON JOSEPH R [US] ET AL) 29 December 2005 (2005-12-29) * abstract; figures 4,6-10 * | 1-14 | |
| X | FR 2 782 169 A1 (ALSTOM TECHNOLOGY [FR]) 11 February 2000 (2000-02-11) * the whole document * | 1-14 | |
| X | US 9 880 217 B1 (VOLKENING FRED A [US] ET AL) 30 January 2018 (2018-01-30) * column 5, line 25 - column 12, line 48; figures 3a, 3b, 3c, 4 * | 1-14 | |
| X | CN 108 919 158 A (ELECTRIC POWER RES INST SICHUAN ELECTRIC POWER CORP ET AL.) 30 November 2018 (2018-11-30) * the whole document * | 1-14 | |
| A | US 6 252 388 B1 (JAEGER NICOLAS AUGUST FLEMING [CA] ET AL) 26 June 2001 (2001-06-26) * abstract; claim 7; figures 1-3 * | 1-14 | TECHNICAL FIELDS SEARCHED (IPC) G01R |
| A | EP 2 577 328 A1 (ABB RESEARCH LTD [CH]) 10 April 2013 (2013-04-10) * abstract; figures 1-3 * * paragraphs [0011] - [0018], [0024] - [0049] * | 1-14 | |

-/--

The present search report has been drawn up for all claims

| Place of search | Date of completion of the search | Examiner |
|---|---|---|
| Munich | 2 December 2020 | Maric, Viktor |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**EUROPEAN SEARCH REPORT**

Europäisches
Patentamt
European
Patent Office
Office européen
des brevets

Application Number

EP 20 18 9839

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KE ZHU ET AL: "Non-Contact Capacitive-Coupling-Based and Magnetic-Field-Sensing-Assisted Technique for Monitoring Voltage of Overhead Power Transmission Lines", IEEE SENSORS JOURNAL., vol. 17, no. 4, 15 February 2017 (2017-02-15), pages 1069-1083, XP055754981, US ISSN: 1530-437X, DOI: 10.1109/JSEN.2016.2636862 * paragraph [000I] - paragraph [II.C]; figures 1-5 * ----- | 1-14 | |

TECHNICAL FIELDS
SEARCHED       (IPC)

The present search report has been drawn up for all claims

| Place of search | Date of completion of the search | Examiner |
|---|---|---|
| Munich | 2 December 2020 | Maric, Viktor |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 2 of 2

## ANNEX TO THE EUROPEAN SEARCH REPORT
## ON EUROPEAN PATENT APPLICATION NO.

EP 20 18 9839

This annex lists the patent family members relating to the patent documents cited in the above-mentioned European search report.
The members are as contained in the European Patent Office EDP file on
The European Patent Office is in no way liable for these particulars which are merely given for the purpose of information.

02-12-2020

| Patent document cited in search report | | Publication date | Patent family member(s) | | Publication date |
|---|---|---|---|---|---|
| EP 0337265 | A1 | 18-10-1989 | DE | 3812055 A1 | 26-10-1989 |
| | | | EP | 0337265 A1 | 18-10-1989 |
| US 2005286190 | A1 | 29-12-2005 | BR | PI0512855 A | 08-04-2008 |
| | | | CA | 2571477 A1 | 19-01-2006 |
| | | | CN | 101027562 A | 29-08-2007 |
| | | | EP | 1761786 A1 | 14-03-2007 |
| | | | US | 2005286190 A1 | 29-12-2005 |
| | | | WO | 2006007131 A1 | 19-01-2006 |
| FR 2782169 | A1 | 11-02-2000 | NONE | | |
| US 9880217 | B1 | 30-01-2018 | NONE | | |
| CN 108919158 | A | 30-11-2018 | NONE | | |
| US 6252388 | B1 | 26-06-2001 | AT | 302417 T | 15-09-2005 |
| | | | AU | 5613799 A | 26-06-2000 |
| | | | CA | 2351573 A1 | 15-06-2000 |
| | | | DE | 69926792 T2 | 08-06-2006 |
| | | | EP | 1137950 A1 | 04-10-2001 |
| | | | JP | 2002532688 A | 02-10-2002 |
| | | | US | 6252388 B1 | 26-06-2001 |
| | | | WO | 0034793 A1 | 15-06-2000 |
| EP 2577328 | A1 | 10-04-2013 | NONE | | |

EPO FORM P0459

For more details about this annex : see Official Journal of the European Patent Office, No. 12/82